# EUROPEAN PATENT APPLICATION

(11) **EP 1 752 778 A2**
(43) Date of publication of application: **14.02.2007**
(21) Application number: 06117699.6
(22) Date of filing: 21.07.2006
(51) Int. Cl.: G01R 31/28

(54) **IC Sorter**

(30) Priority: 09.08.2005 KR 2005072898
(71) Applicant: Mirae Corporation, 330-220 Chungcheongnam-do (KR)
(72) Inventor: Kim, Byoung-woo, Seoul (KR); Seo, Yong-jin, Gyeonggi-do (KR)
(74) Representative: Meissner, Bolte & Partner

(57) **Abstract**

Provided are an IC sorter, a method for sorting a burn-in IC, an IC sorted using the method. The IC sorter according to one embodiment of the present invention includes a board table onto which a burn-in board is loaded, a tray loader and a tray unloader which are spaced from the board table in a first axis direction and extended parallel to each other in a second axis direction, a DC test buffer and unloading buffer which are spaced from the board table in a second axis direction with a working area of the board table in between, a sorting unit spaced from the board table, having at least one DC failure tray receiving ICs which fail a DC test and at least one sorting tray, a DC failure/loading head movable at least among a working location of the tray loader, the DC test buffer and a DC failure tray of the sorting unit, a unloading head movable at least among a working location of the tray unloader and the unloading buffer, a sorting head movable at least among the unloading buffer and the sorting tray of the sorting unit; and an insertion/removal head movable at least among the DC test buffer, the working area of the board table, and the unloading buffer.

## Description

### BACKGROUND OF THE INVENTION

### 1. Field of the Invention

The present invention relates to an IC sorter, method for sorting burn-in ICs and ICs fabricated by the method, and more particularly to an IC sorter which loads ICs, which passed a direct-current test, to a burn-in board and sorts ICs into grade according to a result of a burn-in test.

### 2. Description of the Background Art

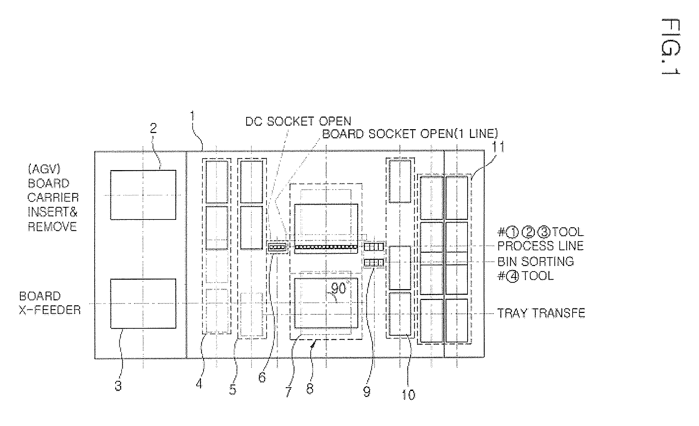

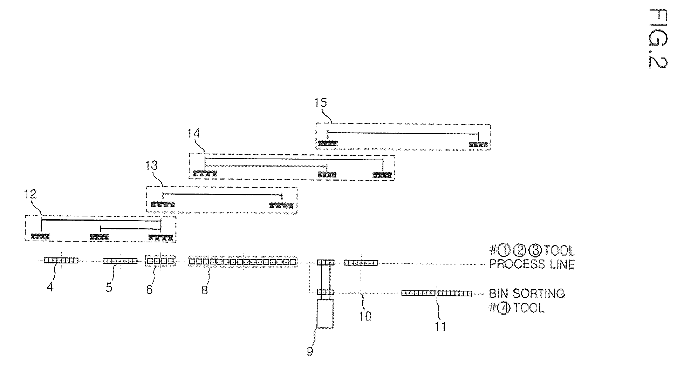

FIG. 1 is a plane drawing showing a configuration of a burn-in sorter described in the laid-open publication No.1998-0071613. FIG. 2 is a drawing showing operations of tools provided on an upper part of the body of the burn-in sorter of FIG. 1. As shown in FIGs 1 and 2, the burn-in sorter includes a board loader 2, a board unloader 3, a DC failure rejecting unit 4, a tray loading unit 5, a DC test unit 6, a turning/returning unit 7, an Y-table 8, a bin pocket unit 9, a tray unloading unit 10, and a sorting unit 11.

The board loader 2 and the board unloader 3 are provided on the upper part of the body 1 of the burn-in sorter. The DC failure rejecting unit 4 and the tray loading unit 5 are provided in parallel adjacent to the board loader 2 and the board unloader 3. The DC test unit 6, the turning/returning unit 7 and the Y-table 8 are provided adjacent to the loading unit 5. The bin pocket unit 9, the tray unloading unit 10 and the sorting unit 11 are provided adjacent to the turning/returning unit 7 and the Y-table 8. Tools 12 through 15 are provided on the upper part of the body 1 of the burn-in sorter.

The first and second transfer tools 12 and 13 among the plurality of tools 12 through 15 are provided to move in an X-axis direction. The first tool 12 moves ICs (not shown) from the tray loading unit 5 to the DC test unit 6. The second fool 13 moves a good IC from the DC test unit 6 to a burn-in board (now shown) positioned at the Y-table 8 and a bad IC from the DC test unit 6 to the DC failure rejecting unit 4. The third tool 14 is provided to move in the X-axis direction and transfer the ICs which finished a burn-in test to the bin pocket unit or the tray unloading unit 10 according to their grades. The fourth tool 15 is provided to move in the X-axis direction and transfer the bad IC from the bin pocket unit 9 to the sorting unit 11.

However, in the conventional burn-in sorter, the plurality of tools are movable only in the x-axis direction. This requires an arrangement of the DC reject unit 4, the tray loading unit 5, the test unit 6, the bin pocket unit 9, the tray unloading unit 10 and the sorting unit 11 along the x-axis direction. Thus, the conventional burn-in sorter has to have a large footprint, resulting in increasing a size of the burn-in sorter. In addition, series connection of the plurality of heads in the conventional burn-in sorter increases the time required to index the plurality of heads.

### BRIEF DESCRIPTION OF THE INVENTION

An object of the present invention is to provide an IC sorter having a structure in which it is possible to reduce a whole size of the an IC sorter by narrowing a footprint.

Another object of the present invention is to provide an IC sorter capable of reducing the time required to index heads.

According to an aspect of the present invention, there is provided an IC sorter including a board table onto which a burn-in board is loaded, a tray loader and a tray unloader which are spaced from the board table in a first axis direction and extended parallel to each other in a second axis direction, a DC test buffer and an unloading buffer which are spaced from the board table in a second axis direction with a working area of the board table in between, a sorting unit which is spaced from the board table and has at least one DC failure tray receiving ICs which fail a DC test and at least one sorting tray, a DC failure/loading head which is movable at least between a working location of the tray loader, the DC test buffer and the DC failure tray of the sorting unit, an unloading/sorting head which is movable at least between a working location of the tray unloader, the unloading buffer, and a sorting tray of the sorting unit, and an insertion/removal head which is movable at least between the DC test buffer, a working area of the board table, and the unloading buffer.

The IC sorter may further a tray transfer connecting between the tray loader and the tray unloader.

The working location of the tray unloader, the unloading buffer, the sorting tray of the sorting unit may be provided in parallel to each other along the first axis . The unloading/sorting head may be provided to move along the first axis.

A working location of the tray loader, the DC test buffer, the DC failure tray of the sorting unit are provided in parallel to each other along the fist axis. The DC failure/loading head may be provided to move along the first axis.

The tray loader and the tray unloader may be spaced relative to each other with the board table in between. Otherwise, the tray loader may be provided to be parallel to each other with the board table facing one of both.

The insertion/removal head may include at least two rows of nozzles which are spaced relative to each other in the first axis direction, as much as are the DC test buffer and the working area of the board table. A distance which the insertion/removal head travels between the DC test buffer and the working area of the board table may be the same as that which the insertion/removal head travels between the unloading buffer and the working area of the board table. The board table may be arranged in such a way that a distance between the DC test buffer and the working area of the board table is the same as that between the unloading buffer and the working area of the board table.

The IC sorter may further include a board loader loading the burn-in board onto the board table and unloader the burn-in board from the board table.

The tray stacker may be provided adjacent to the sorting unit.

According to another aspect of the present invention, there is provided an IC sorter including a board table onto which a burn-in board is loaded, a tray loader and a tray unloader which are spaced from the board table in a first axis direction and extended parallel to each other in a second axis direction, a DC test buffer and unloading buffer which are spaced from the board table in a second axis direction with a working area of the board table in between, a sorting unit which is spaced from the board table and has at least one DC failure tray receiving ICs which fail a DC test and at least one sorting tray, a DC failure/loading head which is movable at least between the working location of the tray loader, the DC test buffer and the DC failure tray of the sorting unit, an unloading head which is movable at least between a working location of the tray unloader and the unloading buffer, a sorting head which is movable at least between the unloading buffer and the sorting tray of the sorting unit, and an insertion/removal head which is movable at least between the DC test buffer, the working area of the board table, and the unloading buffer.

According to another aspect of the present invention, there is provided an IC sorter which moves ICs, performs a DC test on the ICs, and sorts the ICs into grades, including at least one or more heads which are movably provided on both side of a X-axis frame, at least one or more heads which are movably provided in a predetermined direction on one sides of an Y-axis frame provided below the X-axis frame, and a plurality of rows of pickers provided on one side of the head provided on the Y-axis frame.

According to another aspect of the present invention, there is provided a method for sorting burn-in ICs and an IC which is sorted using the method, the method including transferring a burn-in board containing the ICs which finished a burn-in test to a board table and a tray to a working area of a tray loader, transferring the ICs to take a DC test from the tray loader to a DC test buffer by using a DC failure/loading head, performing the DC test on the ICs in the DC test buffer, transferring the ICs which failed the DC test from the DC test buffer to the DC failure tray by using the DC failure/loading head, transferring the ICs contained in the burn-in board to an unloading buffer by using an insertion/removal head, transferring the ICs which passed the DC test from the DC test buffer to an empty socket of the burn-in board by using the insertion/removal head, transferring the tray to a working area of a tray unloader, and transferring the good ICs among the ICs transferred to the unloading buffer to the tray of the tray unloader and the bad ICs among the ICs transferred to the unloading buffer to the sorting tray.

The foregoing and other objects, features, aspects and advantages of the present invention will become more apparent from the following detailed description of the present invention when taken in conjunction with the accompanying drawings.

### BRIEF DESCRIPTION OF THE DRAWINGS

The accompanying drawings, which are included to provide a further understanding of the invention and are incorporated in and constitute a part of this specification, illustrate embodiments of the invention and together with the description serve to explain the principles of the invention.

In the drawings:
Figure 1 is a plane drawing showing a configuration of an conventional burn-in sorter;
Figure 2 is a drawing showing operations of tools provided on an upper part of the body of the burn-in sorter of FIG. 1;
Figure 3 is a plane drawing showing an IC sorter according to a first embodiment of the present invention;
Figure 4 is a plane drawing showing a variant of the embodiment of FIG. 3;
Figure 5A and 5B are drawings showing exemplary operations of insertion/removal head of FIG. 3;
Figure 6 is a plane drawing showing an IC sorter according to a second embodiment of the present invention;
Figure 7 is a plane drawing showing an IC sorter according to a third embodiment of the present invention; and
Figures 8 and 9 are flow charts showing methods for sorting ICs into grade according to the present invention.

### DETAILED DESCRIPTION OF THE INVENTION

Reference will now be made in detail to the preferred embodiments of the present invention, examples of which are illustrated in the accompanying drawings.

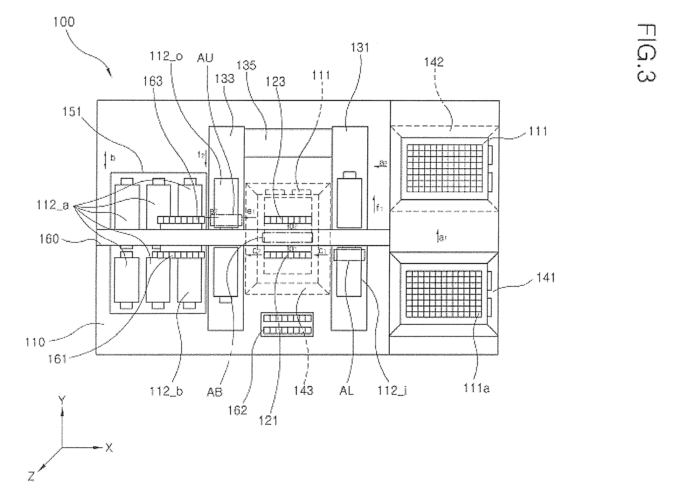

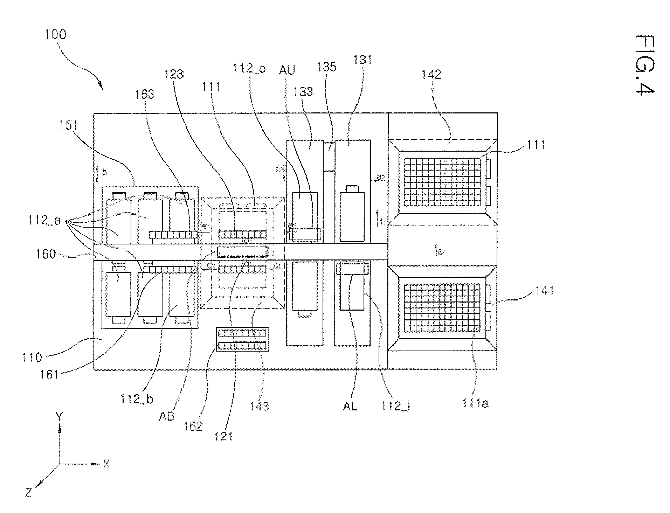

FIG. 3 is a plane drawing showing an IC sorter according to an embodiment of the present invention. FIG. 4 is a plane drawing showing a variant of the embodiment of FIG. 3. Because the IC sorter works classified burn-in tested ICs primarily, the IC sorter will be called a burn-in sorter from below.

As shown in FIGs. 3 and 4, the burn-in sorter 100 includes a board table 143, a tray loader 131, a tray unloader 132, a DC test buffer 121, an unloading buffer 123, a sorting unit 151, a DC failure/loading head 161, an insertion/removal head 162, and an unloading/sorting head 163.

The above-mentioned elements, the board table 143, the tray loader 131, the tray unloader 132, the DC test buffer 121, the unloading buffer 123, the sorting unit 151 may be all provided on a body 110 of the burn-in sorter.

A burn-in board 111 is loaded onto the board table 143. The board table 143 may be provided at the center of the body 100 of the burn-in sorter. A linear movement mover, such as a belt, a ball screw (not shown) or a linear motion guide (not shown), may be provided to move the loaded burn-in board in the X-axis and Y-axis directions. Additionally, a rotational movement mover having a driving motor may be provided to change the direction of the burn-in board 111. The board table 143 has a working area where the insertion/removal head 162 (later described), performs a function of picking up and inserting ICs from and into the burn-in board.

The tray loader 131 and the tray unloader 131 and 133 are provided to extend along a second axis (an Y-axis in FIG. 3) and spaced relative to each other along a first axis (an X-axis in FIG. 3). The tray loader and unloader 131 and 133, as shown in FIG. 3, may be provided to face each other with the board table 143 in between. Otherwise, the tray loader and unloader 131 and 133, as shown in FIG. 4, may be provided to be parallel to each other with the board table 143 facing one of both.

The tray loader 131 moves a tray which contains the ICs to take the direct current (DC) test. A working location (AL) of the tray loader 131 indicates an area where a tray 112 is positioned for the DC failure/ loading head 161 (later described) to pick up the ICs from the tray 112 and transfer the ICs to the test buffer.

The tray unloader 133 transfers the tray in which good ICs which passed a burn-in test are contained. A working location (AU) of the tray unloader 133 indicates an area where the tray 112 is positioned for the unloading/sorting head 163 (later described) to pick up the IC from the unloading buffer and load the IC onto the tray 112.

A stacking framework such as a rack and the linear movement mover (not shown) such as the belt, the ball screw, or the linear movement guide, are provided to the tray loader 131 and the tray unloader 133 to continuously supply the tray 112 containing the ICs to take the DC test and an empty tray 112 to contain the ICs which finished the burn-in test.

The burn-in sorter may further include a tray transfer 135 which connects between the tray loader 131 and the tray unloader 133. The tray transfer 135 automatically transfers the tray 112 from the tray loader 131 to the tray unloader 133. That is, the loading tray 112_i, which moves in the arrow direction f1 on the tray loader 131, goes past the tray transfer 135 and moves in the arrow direction f2 on the tray unloader 133 as an unloading tray 112_o. This makes it possible to automatically reuse the tray which is empty after the DC failure/loading head picks up all the ICs contained in the tray, to contain the IC which finished the burn-in test, without the help of a manual operation or an additional transfer means.

The DC test buffer 121 and the unloading buffer 123 are spaced and arranged relative to each other in the second axis direction (i.e., the Y axis in FIGs 3 and 4) with the board table 143 in between. The DC test buffer 121 is provided adjacent to one of both sides of a space over a working area (AB) of the board table to receive the ICs which are picked up and transferred from the tray loader 131 to take the DC test. The unloading buffer 123 is provided adjacent to the other one of both sides of the space over the working area (AB) of the board table to receive the ICs transferred by the insertion/removal head 162, which finished the burn-in test.

The burn-in sorter may further a DC test/loader aligner (not shown). The DC test/loader aligner moves in the second axis direction to align the ICs which are picked up by the DC failure/loading head 161 to be loaded onto the DC test buffer 121.

The sorting unit 151 may include at least one or more sorting trays 112_a and at least one DC failure tray 112_b. The DC failure tray 112_b contains the ICs which fails the DC test. The ICs which finished the burn-in test are contained in the sorting trays 112 assigned according to their burn-in test grade. The sorting unit 151, as shown in FIGs 3 and 4, includes one DC failure tray 112_b, but may include two or more DC failure trays 112_b, when necessary.

The sorting unit 151 is provided on the body 110 to move at least in the arrow direction b. i.e. the second axis direction (the Y axis in FIGs 3 and 4). With the help of the linear movement mover (not shown) such as the ball screw or the LM guide, the sorting unit 151 moves the plurality of sorting tray 112_a and the DC failure/tray 112_b in the Y-axis direction to their respective working areas.

The working area of the DC failure/tray 112_b may be provided at least in parallel to the working location of the tray loader 131 and the DC test buffer 121. This enables the DC failure/loading head 161 to move only along one axis to load the DC test-failed ICs onto the DC failure/tray 112_b.

The working area of the sorting tray 112_a may be provided in parallel to the working location of the tray unloader 133 and the unloading buffer 123. This enable the unloading/sorting head 163 to move only along one axis to load onto the sorting tray 112_a the ICs which failed the burn-in test.

The DC failure/loading head 161 is provided to move at least among the working location (AL), the DC test buffer 121, and the sorting unit 151. This enables the DC failure/loading head 161 to pick up the ICs to take the DC test from the tray 112 transferred to the working location of the tray loader 131 and move in the first direction (the X-axis in FIGs 3 and 4), i.e., the arrow direction, to transfer the picked-up ICs to the DC test buffer 121. Additionally, the DC failure/loading head 161 picks up the ICs which failed the DC test after finishing the DC test in the DC test buffer, and moves in the arrow direction c2 to transfer the picked-up ICs to the DC failure/tray 112_b loaded onto the sorting unit 151.

The insertion/removal head 162 is provided to move at least among the DC test buffer 121, the board table 143, and the unloading buffer 123. This enables the insertion/removal head 162 to transfer the IC, which passed the DC test, and insert into sockets of the burn-in board loaded onto the board table 143. That is, the insertion/removal head 162, which is provided on the insertion/removal frame (not shown), picks up the ICs from the DC test buffer 121 and moves in the second axis ( the Y-axis in FIGs 3 and 4), i.e. the arrow direction d1 to load the picked-up ICs onto the working area AB of the board table 143. Additionally, the insertion/removal head 162 moves the ICs loaded onto the burn-in board, which finished the burn-in test, in the arrow direction d2 to the unloading buffer 123.

In FIGs 3 and 4, the insertion/removal head 162 is provided outside of the board table 143 for the sake of explanation, but may be provided to move only among the DC test buffer 121, the board table 143, and the unloading buffer 123.

The burn-in sorter according to the embodiment of the present invention, may include at least two rows of nozzles provided on the insertion/removal head 162. The two rows of nozzles in the rows are arranged parallel to each other in the first axis direction. The two rows of nozzles are spaced relative to each other in the first direction, as much as is the DC test buffer 121 and the working area AB of the board table.

A distance which the insertion/removal head 162 travels between the DC test buffer 121 and the working area of the board table is the same as that which the insertion/removal head 162 travels between the working area AB of the board table and the unloading buffer 123. Also, the board table 143 may be movably provided in such a way that a distance between the working area AB of the board table and the DC test buffer 121 is the same as that between the working area AB of the board table and the unloading buffer 123.

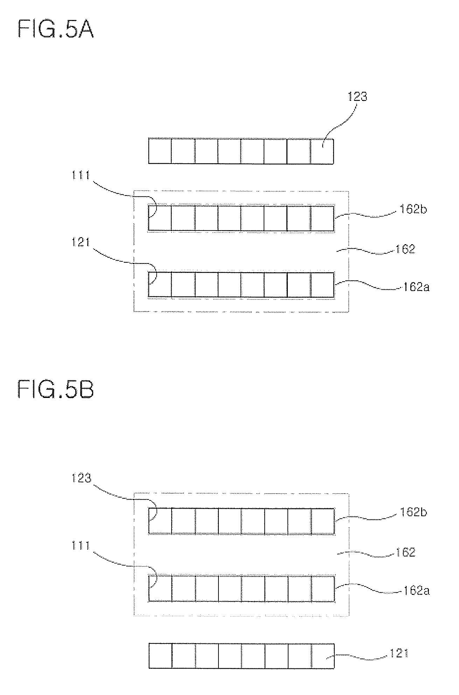

Accordingly, as shown in FIG. 5A, when the fist row 162a of nozzles of the insertion/ removal head 162 descends from the DC test buffer 121 to pick up the ICs which finished the DC test, the second row 162b of nozzles can descend from the working area of the burn-in board to pick up the ICs which finished the burn-in test. Also, as shown in FIG. 5B, when the first row 162a of nozzles of the insertion/ removal head 162 load onto the empty sockets the ICs which finished the burn-in test, the second row 162b of nozzles descend to load onto the unloading buffer 123 the ICs which finished the burn-in test.

Referring back to FIGs 3 and 4, the unloading/sorting head 163 sorts the ICs transferred to the unloading buffer 123 into grade. To do this, the unloading/sorting head 163 is provided to move at least to the unloading buffer 123, the working location AU of the tray unloader 133, and the sorting unit 151. Accordingly, the unloading/sorting head 163, when the ICs which finished the burn-in test are loaded onto the unloading buffer 123, moves in the first axis direction, i.e., the arrow directions e1 and e2 to transfer the ICs which finished the burn-in test to the unloading tray and the sorting unit 151.

The sorting unit 151, as shown in FIGs 3 and 4, is provided toward one side of the board table 143, but not limited to this arrangement. The sorting units 151 may be provided toward both sides of the board table 143.

The burn-in sorter according to the embodiment of the present invention, may include the board loader 141 and the board unloader 143. The board loader 141 and the board unloader 142 supplies and retrieves the burn-in board 111 to and from the board table 143. The board loader 141 supplies the burn-in board to the board table 143 to unload and sort the board which finished the burn-in test. The board unloader 142 unloads from the burn-in sorter the tray 112 containing the ICs which finished the DC test, to perform the burn-in test. That is , the board loader 141 is provided to continuously transfer in the arrow direction a1 and a2 the burn-in board 111 containing the ICs which finished the burn-in test and supply the burn-in board to the board table 143. The board unloader 142 is provided to receive the burn-in board containing the ICs, which passed the DC test, in the direction opposite to the arrow direction a2 and unload the burn-in board. In this case, the board loader 141 and the board unloader 142 may include the rack (not shown) on which to stack the burn-in board and the linear movement mover such as the belt, the ball screw, and the linear movement guide.

The DC failure/loading head 161 and the unloading/sorting head 163, as shown in FIGs 3 and 4, may be movably provided toward both sides of one X-axis frame 160. Also, the insertion/removal head 162 may be movably provided on an Y-axis frame (now shown).

That is, the burn-in sorter may include at least one or more heads which are provided on the X-axis frame 160 and at least one or more heads which are provided on the Y-axis frame. Each of the heads provided on the X-axis frame 160 and the Y-axis frame may perform at least one function selected from among loading, unloading, sorting, inserting, and removing.

The Y-axis frame 160 may be provided below or above the X-axis frame. The heads provided on the Y-axis frame 160 may further include rows of pickers (not shown)

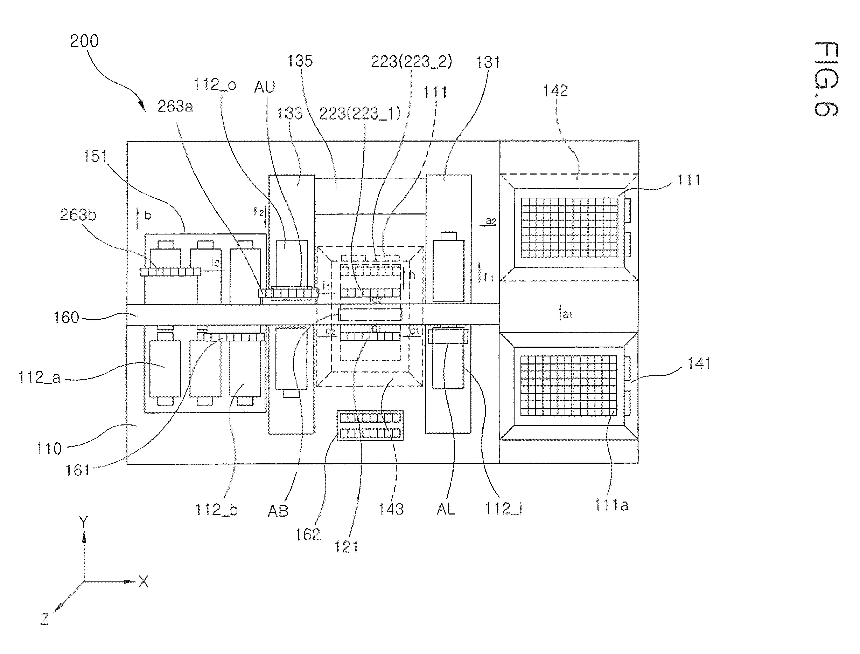

FIG. 6 is a plane drawing showing a configuration of the burn-in sorter according to a second embodiment of the present invention. As shown in FIG 6, the burn-in sorter 200 according to the second embodiment of the present invention, includes a board table 143, a tray loader 131, a tray unloader 133, a DC test buffer 121, an unloading buffer 223, a sorting unit 151, a DC failure/loading head 161, an unloading head 163a, a sorting head 263a, and an insertion/removal head 162. The burn-in sorter 200 may further include a board loader 141 and a board unloader 142.

A burn-in board is loaded onto the board table 143. The tray loader 131 and the tray unloader 133 are spaced relative to each other in a first axis direction of the board table 143 and moves the tray 112 along a second axis, not the first axis. The tray loader 131 and the tray unloader 133 have their respective working area with the board table in between.

The board loader 141 and the board unloader 142 are provided to supply and retrieve the burn-in board to and from the board table 143. The DC test buffer 121 and the unloading buffer 123 are spaced relative to each other in the second-axis direction, not the fist axis direction, with a working area AB of the board table 143 in between. The sorting unit 151 is provided to be spaced from at least one side of each of the board table 143 and the first axis. The DC failure/loading head 161 is provided to move at least among a working location AL of the tray loader, a working area of the board table 143, and the sorting unit 151. The unloading head 263a is provided to move at least between the working location AU of the tray unloader and the unloading buffer 223. The sorting head 263a is provided to move at least between the unloading buffer 223 and the sorting unit 151.

The insertion/removal head 162 is provided to move at least between the DC test buffer 121, the working area AB of the board table, and the unloading buffer 123.

The structures and functions of he board table 143, the tray loader, the tray unloader 131, the board loader 141, the board unloader 142, the DC test buffer 121, the sorting unit 151, the DC failure/loading head 161, and the insertion/removal head 162 are substantially the same as those of the first embodiment of the present invention. Therefore, like reference numerals are used in the second embodiment. An unloading buffer 223, an unloading head 263a, and a sorting head 263b are now described in detail.

The burn-in sorter according to the second embodiment of the present invention additionally includes an unloading head 263a and a sorting head 263b. The unloading head 263a is provided to move at least between a working location AU of the tray unloader 133 and the unloading buffer 223. Also, the sorting head 263b is provided to move at least between the unloading buffer 223 and the sorting unit 151.

The unloading buffer 223 may be provided to move in a second axis (the Y aixs in FIGs), i.e. the arrow direction h. For example, the unloading buffer 223 may be provided to move from a first position to a second position which is spaced from the first position in the second axis direction. The unloading buffer 223_1 at the first position may be provided to be in parallel to the working location AU of the tray unloader along the first axis. The unloading buffer 223_2 at the second position may be provided to be in parallel to the sorting tray 112_a along the first axis. Accordingly, the unloading head 263a and the sorting head 263b may be provided to move along the first axis from their respective positions which are in the second axis direction.

This enables the unloading head 263a to pick up the good ICs, when the insertion/removal head 162 moves in the second axis direction, i.e., the arrow direction d2 and transfer the ICs which finished the burn-in test, to the unloading buffer 223_1 at the first position. Thereafter, the unloading buffer 223 moves in the arrow direction h to be positioned at the second position. When the unloading buffer 223_2 is positioned at the second position, the sorting head 163a picks up the ICs remaining in the unloading buffer 223_2 at the second position.

The unloading head 263a and the sorting head 263b moves in the arrow directions i1 and i2, respectively, when the unloading head 263a picks up the good ICs and the sorting head 263b picks up the bad ICs among the ICs contained in the unloading buffer 223, which finished the burn-in test. Thereafter, the unloading head 263a and the sorting head 263b transfer the good ICs to the working area AU of the tray unloader 133 and the bad ICs to the sorting unit 151, respectively. resulting in all the ICs being contained in their respective sorting tray assigned according to their grades.

In this case, the distance between the first position and the second position does not need to be long. The time for the unloading buffer to move from the first position to the second position and the time for the unloading buffer to return from the second position to the first position get shorter in proportion to the distance between the first position and the second position. The distance between the first position and the second position may be as short as possible. A reduction in the time for the unloading buffer 223_1 to remain at the first position without containing the ICs makes it possible to speed up a continuous operation of the insertion/removal head 162, thus shortening the time for indexing the head.

The burn-in sorter 200 according the second embodiment of the present invention may employ various arrangements in addition to the arrangement of the tray loader and unloader as shown in FIGs 3 and 4.

In one of various arrangements, the burn-in sorter 200 may include at least one or more heads which are movably provided on the X-axis frame 160 and at least one or more heads which are movably provided on the Y-axis frame. Each of the heads provided on the X-axis frame 160 and the Y-axis frame may perform one function selected from among loading, unloading, sorting, inserting, and removing, depending on a user's need.

The Y-axis frame may be provided below or above the x-axis frame. The head provided on the Y-axis frame may further include rows of pickers

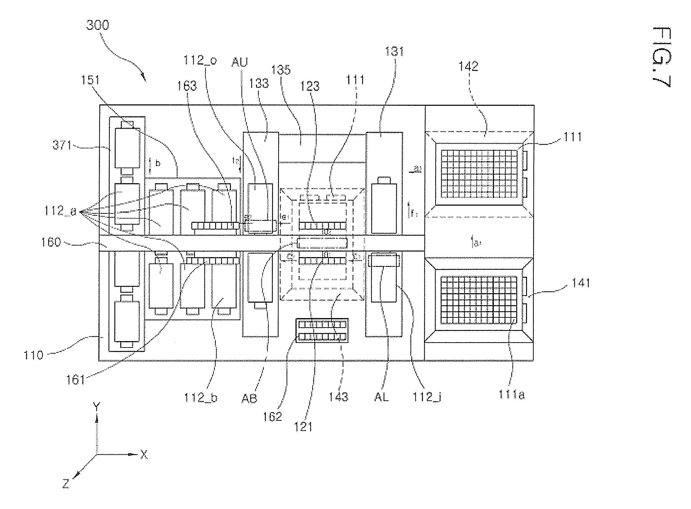

FIG. 7 is a drawing of a third embodiment of the burn-in sorter according to the present invention. The burn-in sorter 300 according to the third embodiment of the present invention further includes a tray stacker 371.

The tray stacker 371 is provided on one side of the sorting unit 151, where at least one or more empty tray is provided. The ICs can be contained in many of the tray 112 which are loaded onto the tray stacker along with the sorting unit 151. This does not necessitate frequently replacing the tray 112 when a lot of ICs have to be sorted into grade after finishing the burn-in test. FIG.7 shows that the stacker 371 is added in FIG. 3, but the stacker 371 may be provided on the burn-in sorter having the structure as shown in FIGs 4 and 6.

The burn-in sorter 300 may include at least one or more heads which are movably provided on the X-axis frame 160, and at least one or more heads which are movably provided on the Y-axis frame. Each of the heads provided on the X-axis frame 160 and the Y-axis frame may perform one function selected from among loading, unloading, sorting, inserting, and removing.

The Y-axis frame may be provided below or above the x-axis frame. The head provided on the Y-axis frame may further include rows of pickers

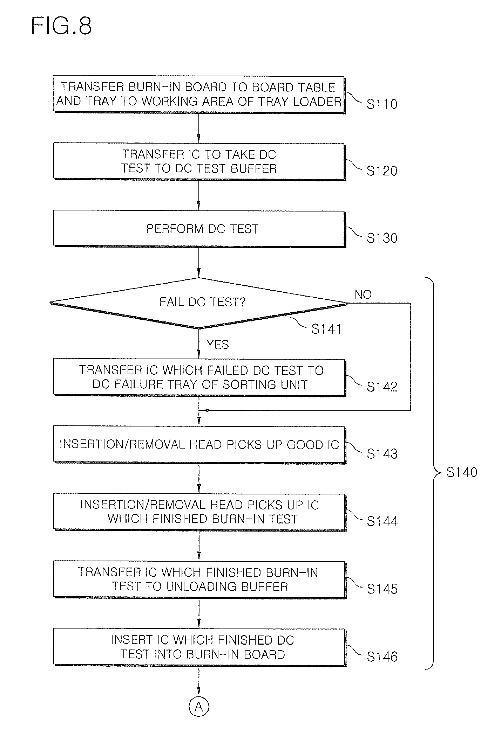

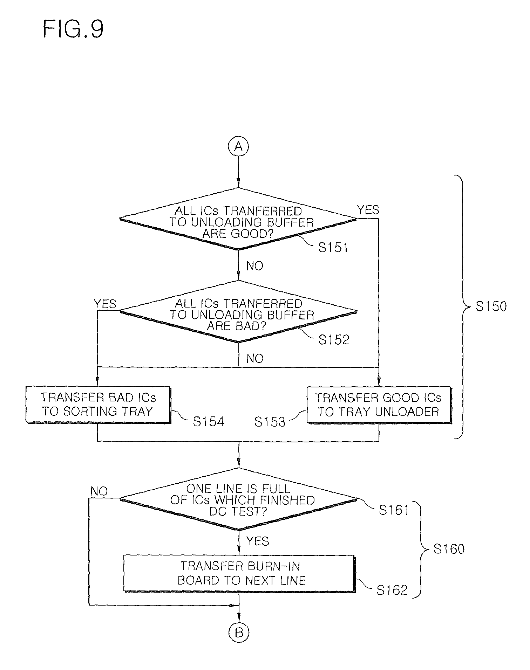

Referring to FIGs 3 through 9, a method for sorting a burn-in IC is now described which is employed in the burn-in sorter according to the embodiments of the present invention.

A burn-in board 111 is transferred to a working area AB of a board table 143 and a tray 112 to a working location AL of a tray loader (S110).

ICs are transferred from the working location AL of the tray loader 131 to the DC test buffer(S120) and the DC failure/loading head 161 performs the DC test on the ICs (S130). That is, in performing the DC test on the ICs, the DC failure/loading head 161 transfers the ICS from the working location AL to the DC buffer 121 to performing the DC test and the DC test is performed on the ICs at the DC test buffer 121.

It is determined if the ICs fails the DC test. The insertion/removal head picks up the ICs which passed the DC test, from the DC test buffer 121 and transfers the ICs which passed the DC test, to the burn-in board 111. The insertion/remove head picks up the ICs which finished the burn-in test, from the burn-in board 111 and inserts the ICs into the unloading buffer 123 (S140). The above operation (S140) may be divided as follows. It is determined if the ICs fails the DC test (S141). The ICs which failed the DC test are transferred to the DC failure tray 112_b of the sorting unit 151 (S142). The ICs which passed the DC test is picked up by the insertion/removal head 162 (S143). The ICs which finished the burn-in test are picked up by the insertion/removal head 162 (S144). The ICs which finished the burn-in test are transferred to the unloading buffer 123 (S145), The ICs which finished the DC test are inserted into the burn-in board 111 (S146)

At the same time that the ICs which passed the DC test are picked up from the DC test buffer 121 (S143), the ICs which finished the burn-in test may be picked up from the burn-in board (S144). Also, at the same time that the ICs which finished the burn-in test are transferred to the unloading buffer 123 (S145), the ICs which finished the DC test may be inserted into the burn-in board (S146).

The unloading/sorting head 163 transfers the good ICs among the ICs transferred to the unloading buffer 123, to the unloading tray 112_o positioned at the working location AU of the unloader 133, and the bad ICs among the ICs to the sorting tray 112_a of the sorting unit 151, depending on their grade (S150). The above operation S150 may be divided as follows. It is determined if the ICs which are transferred to the unloading buffer 123 are all good (S151). It is determined if the ICs which are transferred to the unloading buffer 123 are all bad (S152). The good ICs are transferred to the working location AU of the tray unloader 133 (S153). The bad ICs are transferred to the sorting unit 151 (S154). For example, assume that a number of the ICs transferred to the unloading buffer 123 after finishing the burn-in test is 8. If at least one or more ICs is bad, the bad ICs are picked up and transferred to the sorting unit 151. The transferred ICs are contained in the sorting trays 112_a assigned according to their grades. The good ICs are transferred to the unloading area AU of a tray unloader 133.

In determining if the ICs transferred to the unloading buffer 123 after finishing the burn-in test are all good, when all the ICs are good, all the ICs are transferred to the working location AU of the tray unloader 133. In determining if the ICs transferred to the unloading buffer 123 after finishing the burn-in test are all bad, when all the ICs turn are bad, all the ICs are transferred to the sorting unit 151.

When one working line of the burn-in board is full of the ICs during the operation of transferring the good ICs or the bad ICs to the working location AU of the tray unloader 133 or the sorting unit 151, the burn-in boards are transferred to another working line (S160). This operation S160 is divided as follows. It is determined if the burn-in board 111 is full of the ICs which finished the burn-in test, during the operation of transferring the ICs which finished the burn-in test to the sorting unit 151 and the working location AU of the tray unloader 133 (S161). When one working line of the burn-in board is determined as full of the good ICs, the burn-in board is transferred to another working line to contain the ICs which finished the DC test (S162) The working line 111 means one row of sockets provided in the first axis direction with respect to the burn-in board loaded onto the board table 143

When the burn-in board is full of the ICs which finished the DC test, the board is transferred from the board table 143 to the board unloader 142. A new burn-in board is transferred from the board loader 141 to the board table 143.

In FIGs, the first and second axes are described in terms of the X- axis and the Y-axis which are normal to each other. The first and second axes may not be necessarily normal to each other.

The present invention provides an advantage of decreasing a size of the burn-in sorter by arranging at least some of the working area AB of the board table, the working location Al of the tray loader 131, the working location AU of the tray unloader 130, the DC test buffer 121, the unloading buffer 123 and 223, and the sorting unit 151 in such a way that they are intersected relative to each other. The arrangement, in which the DC test buffer and the unloading buffer are provided respectively on both sides of the board table, and the insertion/removal head is provided to move between the DC test buffer and the unloading buffer, can reduce the time for indexing a plurality of heads, thus increasing productivity.

The present invention provides another advantage of reducing a number of the tray moving means and the device driving the tray moving means by providing the loading/unloading areas along the same axis and moving the trays with one driving unit. This makes it possible to speed up the sorting operation and reduce the time for indexing the heads, resulting in improving productivity. Furthermore, the reduction of the size of the burn-in sorter can save space for the production line.

As the present invention may be embodied in several forms without departing from the spirit or essential characteristics thereof, it should also be understood that the above-described embodiments are not limited by any of the details of the foregoing description, unless otherwise specified, but rather should be construed broadly within its spirit and scope as defined in the appended claims, and therefore all changes and modifications that fall within the metes and bounds of the claims, or equivalents of such metes and bounds are therefore intended to be embraced by the appended claims.

## Claims

1. an IC sorter comprising:
a board table onto which a burn-in board is loaded ;
a tray loader and a tray unloader which are spaced from the board table in a first axis direction and extended parallel to each other in a second axis direction;
a DC test buffer and an unloading buffer which are spaced from the board table in a second axis direction with a working area of the board table in between;
a sorting unit spaced from the board table, having at least one DC failure tray receiving ICs which fail a DC test and at least one sorting tray;
a DC failure/loading head movable at least among a working location of the tray loader, the DC test buffer and the DC failure tray of the sorting unit;
an unloading/sorting head movable at least among a working location of the tray unloader, the unloading buffer, and a sorting tray of the sorting unit; and
an insertion/removal head movable at least among the DC test buffer, a working area of the board table, and the unloading buffer.

2. The IC sorter according to claim 1, further comprising a tray transfer connecting between the tray loader and the tray unloader.

3. The IC sorter according to claim 1, wherein the working location of the tray unloader, the unloading buffer, and the sorting tray of the sorting unit are arranged in parallel to each other along a first axis, and the unloading/sorting head is movable along the first axis.

4. The IC sorter according to claim 1, wherein a working location of the tray loader, the DC test buffer, and the DC failure tray of the sorting unit are arranged in parallel to each other along a first axis, and the unloading/sorting head is movable along the first axis.

5. The IC sorter according to claim 1, wherein the tray loader and the tray unloader are spaced relative to each other with the board table in between.

6. The IC sorter according to claim 1, wherein the tray loader and the tray unloader are arranged in the same direction with respect to the board table.

7. The IC sorter according to claim 1,
wherein the insertion/removal head may include at least two rows of nozzles which are spaced relative to each other in a first axis direction, as much as are the DC test buffer and the working area of the board table, and
wherein a distance which the insertion/removal head travels between the DC test buffer and a working area of the board table may be the same as that which the insertion/removal head travels between the unloading buffer and the working area of the board table.

8. The IC sorter according to claim 1, further comprising:
a board loader loading the burn-in board onto the board table; and
a board unloader unloading the burn-in board from the board table.

9. The IC sorter according to claim 1, further comprising a tray stacker provided on one side of the sorting unit.

10. An IC sorter comprising:
a board table onto which a burn-in board is loaded;
a tray loader and a tray unloader which are spaced from the board table in a first axis direction and extended parallel to each other in a second axis direction;
a DC test buffer and unloading buffer which are spaced from the board table in a second axis direction with a working area of the board table in between;
a sorting unit spaced from the board table, having at least one DC failure tray receiving ICs which fail a DC test and at least one sorting tray;
a DC failure/loading head movable at least among a working location of the tray loader, the DC test buffer and a DC failure tray of the sorting unit;
a unloading head movable at least between a working location of the tray unloader and the unloading buffer;
a sorting head movable at least between the unloading buffer and the sorting tray of the sorting unit; and
an insertion/removal head movable at least among the DC test buffer, the working area of the board table, and the unloading buffer.

11. The IC sorter according to claim 10, further comprising a tray transfer connecting between the tray loader and the tray unloader.

12. The IC sorter according to claim 10, wherein the unloading buffer and the sorting tray of the sorting unit are arranged in parallel to each other along a first axis, and the sorting head is movable along the first axis.

13. The IC sorter according to claim 10, wherein the working location of the tray loader, the DC test buffer, the DC failure tray of the sorting unit are arranged in parallel to each other along a fist axis, and the DC failure/loading head is movable along the first axis.

14. The IC sorter according to claim 10, wherein the tray loader and the tray unloader are spaced relative to each other with the board table in between.

15. The IC sorter according to claim 10, wherein the tray loader and the tray unloader are arranged in the same direction with respect to the board table.

16. The IC sorter according to claim 10,
wherein the insertion/removal head may include at least two rows of nozzles which are spaced relative to each other in a first axis direction, as much as are the DC test buffer and the working area of the board table, and
wherein a distance which the insertion/removal head travels between the DC test buffer and a working area of the board table may be the same as that which the insertion/removal head travels between the unloading buffer and the working area of the board table.

17. The IC sorter according to claim 10, further comprising:
a board loader loading the burn-in board onto the board table; and
a board unloader unloading the burn-in board from the board table.

18. The IC sorter according to claim 10, further comprising a tray stacker provided on one side of the sorting unit.

19. An IC sorter which moves ICs, performs a DC test on the ICs, and sorts the ICs into grades, comprising:
at least one or more heads which are movably provided on both sides of a X-axis frame;
at least one or more heads which are movably provided in a predetermined direction on one side of an Y-axis frame provided below the X-axis frame; and
a plurality of rows of pickers provided on one side of the head provided on the Y-axis frame.

20. The IC sorter which moves ICs, performs a DC test on the ICs, and sorts the ICs into grades, according claim 19, further comprising a DC test buffer and an unloading buffer which are movably provided to be spaced from the burn-in board.

21. The IC sorter which moves ICs, performs a DC test on the ICs, and sorts the ICs into grades, according claim 19, wherein the DC test buffer can perform the DC test while moving to a predetermined position.

22. The IC sorter which moves ICs, performs a DC test on the ICs, and sorts the ICs into grades, according claim 19, wherein each of the heads can perform at least one or more functions selected from among loading, unloading, sorting, inserting and removing.

23. A method for sorting burn-in ICs, comprising:
transferring a burn-in board containing the ICs which finished a burn-in test to a board table and a tray to a working area of a tray loader;
transferring the ICs to take a DC test from the tray loader to a DC test buffer by using a DC failure/loading head;
performing the DC test on the ICs in the DC test buffer;
transferring the ICs which failed the DC test from the DC test buffer to the DC failure tray by using the DC failure/loading head;
transferring the ICs contained in the burn-in board to an unloading buffer by using an insertion/removal head;
transferring the ICs which passed the DC test from the DC test buffer to an empty socket of the burn-in board by using the insertion/removal head;
transferring the tray to a working area of a tray unloader, and
transferring the good ICs among the ICs transferred to the unloading buffer to the tray of the tray unloader and the bad ICs among the ICs transferred to the unloading buffer to the sorting tray.

24. The method for sorting burn-in ICs according to claim 23, wherein the transferring of the good ICs among the ICs transferred to the unloading buffer to the tray of the tray unloader and the bad ICs among the ICs transferred to the unloading buffer to the sorting tray comprises:
determining if the ICs transferred to the unloading buffer is good or bad; and
selectively transferring the good ICs from the unloading buffer to the tray unloader and the bad ICs from the unloading buffer to the sorting tray.

25. The method for sorting burn-in ICs according to claim 24, wherein an unloading/sorting head selectively performs the good ICs from the unloading buffer to the tray unloader and the bad ICs from the unloading buffer to the sorting tray.

26. The method for sorting burn-in ICs according to claim 24, wherein the good ICs are transferred by an unloading head and the bad ICs are transferred by a sorting head, in selectively transferring the good ICs from the unloading buffer to the tray unloader and the bad ICs from the unloading buffer to the sorting tray

27. The method for sorting burn-in ICs according to claim 23, further comprising transferring the tray from the tray loader to the tray unloader.

28. The method for sorting burn-in ICs according to claim 25, wherein a moving direction of the insertion/removal head intersects a moving direction of the unloading/sorting head.

29. An IC which is sorted using a method comprising:
transferring a burn-in board containing the ICs which finished a burn-in test to a board table and a tray to a working area of a tray loader;
transferring the ICs to take a DC test from the tray loader to a DC test buffer by using a DC failure/loading head;
performing the DC test on the ICs in the DC test buffer;
transferring the ICs which failed the DC test from the DC test buffer to the DC failure tray by using the DC failure/loading head;
transferring the ICs contained in the burn-in board to an unloading buffer by using an insertion/removal head;
transferring the ICs which passed the DC test from the DC test buffer to an empty socket of the burn-in board by using the insertion/removal head;
transferring the tray to a working area of a tray unloader, and
transferring the good ICs among the ICs transferred to the unloading buffer to the tray of the tray unloader and the bad ICs among the ICs transferred to the unloading buffer to the sorting tray.

30. The IC which is sorted using the method according to claim 29, wherein the transferring of the good ICs among the ICs transferred to the unloading buffer to the tray of the tray unloader and the bad ICs among the ICs transferred to the unloading buffer to the sorting tray comprises:
determining if the ICs transferred to the unloading buffer is good or bad; and
selectively transferring the good ICs from the unloading buffer to the tray unloader and the bad ICs from the unloading buffer to the sorting tray.

31. The IC which is sorted using the method according to claim 30, wherein an unloading/sorting head selectively performs the good ICs from the unloading buffer to the tray unloader and the bad ICs from the unloading buffer to the sorting tray.

32. The IC which is sorted using the method according to claim 30, wherein the good ICs are transferred by an unloading head and the bad ICs are transferred by a sorting head, in selectively transferring the good ICs from the unloading buffer to the tray unloader and the bad ICs from the unloading buffer to the sorting tray

33. The IC which is sorted using the method according to claim 31, wherein a moving direction of the insertion/removal head intersects a moving direction of the unloading/sorting head.
